(19) **Europäisches Patentamt**

**European Patent Office**

**Office européen des brevets**

(11) **EP 0 734 594 B1**

(12) **EUROPEAN PATENT SPECIFICATION**

(45) Date of publication and mention
of the grant of the patent:
**01.03.2000 Bulletin 2000/09**

(51) Int. Cl.[7]: **H01P 1/20**, H03H 7/52

(21) Application number: **95903425.7**

(86) International application number:
**PCT/GB94/02747**

(22) Date of filing: **15.12.1994**

(87) International publication number:
**WO 95/17023 (22.06.1995 Gazette 1995/26)**

(54) **MICROWAVE FILTER**

MIKROWELLENFILTER

FILTRE HYPERFREQUENCE

(84) Designated Contracting States:
**AT BE CH DE DK ES FR GR IE IT LI LU MC NL PT SE**

(30) Priority: **15.12.1993 GB 9325661**

(43) Date of publication of application:
**02.10.1996 Bulletin 1996/40**

(73) Proprietor: **Filtronic PLC
Saltair, Shipley BD18 3TT (GB)**

(72) Inventor: **RHODES, John, David
West Yorkshire LS28 1AB (GB)**

(74) Representative:
**Gibson, Stewart Harry
URQUHART-DYKES & LORD,
Three Trinity Court,
21-27 Newport Road
Cardiff CF2 1AA (GB)**

(56) References cited:
**US-A- 4 296 389          US-A- 4 418 324
US-A- 4 538 123**

- **TELECOMMUNICATIONS, vol. 39/49,no. 5, May 1985 WASHINGTON US, pages 108-111, A.YE. ZNAMENSKIY ET AL. 'A method of designing microwave AFR and PFR equalizers'**
- **MATTHAEI ET AL. 'Microwave filters,impedance-matching networks,and coupling structures' 1964 , MCGRAW-HILL , NEW YORK see page 85 - page 86**

**Description**

This invention relates to a microwave filter and more particularly to a variable Q reflection mode microwave filter.

All passive resonators have a finite unloaded Q factor. In narrow bandwidth applications, this resistive loss can lead to difficulties in the design process. In a bandpass application, designs which provide for both a good input and output match exhibit transfer characteristics with significant amplitude variation over the passband if mid band loss is minimised. This passband variation can only be reduced with given Q factors if the mid band loss is increased, possibly to an unacceptable level. Even in the case of a single resonator, filter problems occur due to the resistive loss which prevents a good input and output match being simultaneously achievable.

In the case of a narrow band bandstop application, the resistive loss of the resonators causes a roll-off of the insertion loss into the passband. A reduction in unloaded Q can quickly cause this loss to reach an unacceptable level, particularly where noise figure is important and the notch filter has been introduced to reject signals which would limit the dynamic range of the receiver. This requirement now exists in several countries where cellular telephone systems have multi-operator configurations.

In a conventional bandstop filter, resonators are coupled off from a main through-line with an electrical separation of an odd number of 90°. Each resonator couples loss into the system and this can be further increased by additional loss in the through-line. To meet a typical requirement at 900MHz, at least 20dB rejection has to be provided over a band in excess of 1MHz, whilst the loss at the 1.5MHz bandwidth is less than 2dB. To achieve this, unloaded Q's of greater than 20,000 are required, resulting in the necessity to use dielectric resonators for all of the cavities.

To meet rejection levels of 20 to 30dB, an alternative method may be used based upon the use of a bandpass filter connected to a 3dB hybrid, as set out in UK patent application No. 9324149.5 (GB-A-2284311): this "hybrid notch filter" is more "compact and provides a slightly lower loss, but still needs unloaded Q's of the order of 20,000 for all cavities. However, we have now devised a filter which acts as a true reflection mode filter and meets the above requirements with much lower unloaded Q's.

The paper "A method of designing microwave AFR and PFR equalizers", by A. Ye. Znamenskiy et al, at pages 108 to 111 of "Telecommunications, Vol. 39/49, No. 5 May 1985, discloses a microwave reflection mode filter comprising a circulator device having first, second and third ports, the first port forming a signal input port and the third port forming a signal output port, and a one-port filter connected to and terminating the second part of the circulator device.

In one form, to provide a maximally flat response, the reflection mode filter of the present invention is characterised in the manner defined in claim 1.

In another form, to provide an equiripple or quasi-equiripple response, the reflection mode filter of the present invention is characterised in the manner defined in claim 5.

In each form of the reflection mode filter of the present invention, transmission zeros may be formed by coupling provided between the input of the one-port filter and one of its resonators (e.g. the third resonator).

It will be appreciated that low loss circulators, suitable for use in the filter of this invention, are readily available on the market.

Embodiments of this invention will now be described by way of examples only and with reference to the accompanying drawings, in which:

FIGURE 1 is a schematic diagram of a filter in accordance with this invention;
FIGURE 2 is a diagram for use in explaining principles on which the filter of Figure 1 is based;
FIGURE 3 is a schematic diagram of a lossy ladder network for use in the filter of Figure 2;
FIGURE 4 shows the theoretical quasi equiripple response (with 20dB stopband level) of a filter having a 7th degree ladder network;
FIGURE 5 is a diagram of a ladder network for a filter having a quasi equiripple response;
FIGURE 6 shows the measured response of a 5th degree filter in accordance with the invention;
FIGURE 7 shows the measured response of a 6th degree filter in accordance with the invention;
FIGURE 8 shows the measured response of a 6th degree filter which includes cross-coupling; and
FIGURE 9 shows the passband loss of the 6th degree filter with cross-coupling.

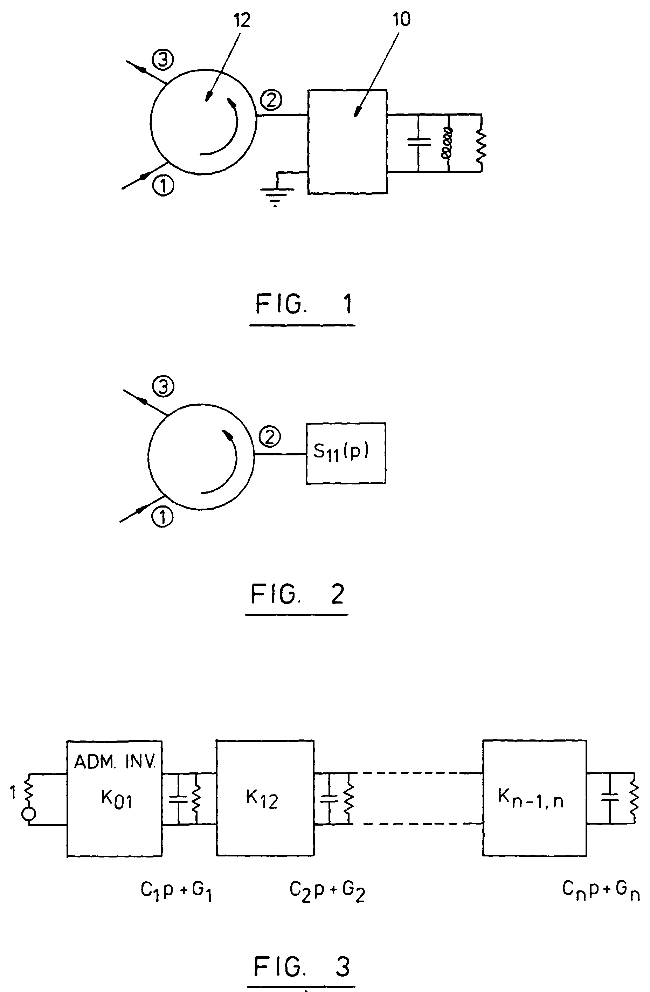

Referring to Figure 1 of the drawings, there is diagrammatically shown a filter which comprises a resonant circuit 10 with loss, coupled to one of the ports of a circulator 12. The transmission characteristic from ports 1 to 3 of the circulator is the reflection characteristic from the network 10 connected to port 2. Assume that the coupling into the resonant circuit is adjusted such that the resistive part at resonance is matched to the impedance of the circulator, then at resonance all of the power supplied at port 1 emerges at port 2 and is absorbed in the resistive part of the resonator. Hence, there is no transmission to port 3. In this case the transmission characteristic from ports 1 to 3 of the circulator is of a single resonator with an infinite rejection at centre frequency, i.e. as if the resonance were from a resonator of infinite unloaded Q. If fo is the centre frequency and B the 3dB bandwidth of the resonance, then by a simple calculation the unload Q (Qu) of the resonator is given by:

$$Qu = \frac{2fo}{B} \qquad (1)$$

For example if B = 250KHz and fo = 1GHz, then Qu = 8,000. This shows that the type of specification previously considered can be met with cavities of much lower Qu if a design procedure is established for a multi-element filter.

The following discussion concerns the design for a variable Q reflection mode filter and in particular designs which provide a maximally flat response and a quasi equiripple response. The discussion provides solutions to the approximation problem and subsequent investigation of the synthesis leads to explicit design formulas for filters of arbitrary degree. Two examples of 5th and 6th degree filters will be given designed around the previous specification and the measured results are shown to be in good agreement with theory. Furthermore, it will be shown that by adding transmission zeros into the reflection mode filter, further enhancement in effective unloaded Q can be obtained: a 6th degree device will be discussed to demonstrate this point.

Firstly a reflection mode filter with a Maximally Flat response will be discussed with reference to Figure 2. Using a circulator, the reflection coefficient $S_{11}(p)$ of a reflection mode filter becomes the transmission coefficient of the overall device shown in Figure 2. Assuming that the circulator 12 is normalised to $1\Omega$ impedance, then in lowpass prototype form as shown in Figure 3 a Maximally Flat response will be achieved if:

$$|S_{11}(j\omega)|^2 = \frac{\omega^{2n}}{D_n(\omega^2)} \qquad (2)$$

where n is the degree of the filter and $D_n(\omega^2)$ is a polynomial of degree n in $\omega^2$ with:

$$\omega^{2^n} \leq D_n(D^n \Rightarrow D_n)(\omega^2) \qquad (3)$$

For the normal maximally flat response:

$$|S_{11}(j\omega)|^2 = \frac{\omega^{2n}}{1+\omega^{2n}} \qquad (4)$$

and the resulting network is a lowpass ladder network with infinite Qu terminated in a $1\Omega$ resistor.

Initially consider the case where each resonator will have the same Qu. Assume that the ratio of conductance to capacitance of each shunt element is normalised to ½ and using the transformation

$$z = 2p + 1 \qquad (5)$$

then the input admittance of the network may be expressed as a reactance function Y(z). Hence:

$$S_{11}(p) = \frac{1 - Y(z)}{1 + Y(z)} \qquad (6)$$

where p is the complex frequency variable ($p = j\omega$ assuming a sinusoidal input signal) and for a maximally flat response around p = 0:

$$S_{11}(p) = \left(\frac{1-z}{1+z}\right)^n \qquad (7)$$
$$= \left[\frac{-p}{1+p}\right]^n$$

where:

$$Y(z) = \frac{(1+z)^n - (1-z)^n}{(1+z)^N + (1-z)^n} \qquad (8)$$
$$= \tanh[n \tanh^{-1}(z)]$$

Now:

$$|S_{11}(j\omega)|^2 = \frac{\omega^{2n}}{(1+\omega^2)^n} \qquad (9)$$

and let the return loss $L_R = L_1$ ($\approx$20dB) for $\omega < \omega_s$ and $L_R = L_2$ ($\approx$ 1dB) for $\omega > \omega_p$, then:

$$10\log\left[1 + \frac{1}{\omega_s^2}\right]^n = L_1 \qquad (10)$$

and

$$10\log\left[1 + \frac{1}{\omega_p^2}\right]^n = L_2 \qquad (11)$$

Therefore:

$$\frac{.1}{\omega_s^2} = 10^{\frac{L_1}{10n}} - 1 \qquad (12)$$

$$\frac{1}{\omega_p^2} = 10^{\frac{L_2}{10n}} - 1$$

and for n large:

$$\frac{\omega_p}{\omega_s} \rightarrow \frac{L_1}{L_2} \qquad (13)$$

and hence there is a fundamental limit to the ratio of the passband frequency to the stopband frequency.

To achieve the objective, a response is required between the response in equation (4) and that in equation (9). One such response is:

$$|S_{11}(j\omega)|^2 = \sum_{r=0}^{n} \frac{\omega^{2n}}{\omega 2^r} \qquad (14)$$

$$= \frac{(1-\omega^2)\omega^{2^n}}{(1-\omega^{2^{n+2}})}$$

In this case:

$$10\log\left[\frac{1-\frac{1}{\omega_s^{2n+2}}}{1-\frac{1}{\omega_S^2}}\right] = L_1 \qquad (15)$$

and

$$10\log\left[\frac{1-\frac{1}{\omega_p^{2n+2}}}{1-\frac{1}{\omega_p^2}}\right] = L_2 \qquad (16... )$$

hence:

$$\frac{1}{\omega_S^2} \approx 10^{\frac{L^1}{10n}}$$

$$\frac{1}{\omega_p^2} \approx 1-10^{\frac{-L_2}{10}}$$

and

$$\frac{\omega_p}{\omega_s} = \frac{10^{\frac{L1}{20n}}}{\sqrt{1-10^{\frac{-L_2}{10}}}} \qquad (16)$$

For $L_1$ = 20dB, $L_2$ = 1dB and n = 7:

as compared to 1.53 from the normal maximally flat response given in equation (4).

From equation (14) the following bounded real reflection coefficient may be formed:

$$S_{11}(p) = \prod_{r=1}^{n} \frac{p^n}{(p-je^{j\theta r})} \qquad (17)$$

with

$$\theta_r = \frac{r\pi}{n+1} \qquad (18)$$

Forming the input admittance

$$Y(p) = \frac{1-S_{11}(p)}{1+S_{11}(p)} \qquad (19)$$

and synthesising as the lossy ladder network shown in Fig 3, explicit formulas are obtained for element values given by:

$$K_{r-1,r} = 1 \qquad r=1\rightarrow n \qquad (20)$$

and if

$$E_o = 1 \qquad (21)$$

$$E_{r-1}E_r = \left[\frac{\cos\theta+\cos(r\theta)}{\cos\theta+\cos((r-1)\theta)}\right] \qquad r=1\rightarrow n$$

with

$$\theta = \frac{\pi}{n+1}$$

then:

$$c_r = \frac{1}{\cos\theta}\left[\frac{\sin((r-1)\theta)}{E_{r-1}}+\sin(r\theta)E_r\right]$$

where $E_r$ and $E_{r-1}$ are intermediate variables and $C_r$ is the capacitance of the $r^{th}$ resonator, and

$$\frac{\omega_p}{\omega_s} = 3.06$$

$$G_r = \frac{1}{E_{r-1}} - E_r \qquad (22)$$

where $G_r$ is the conductance of the $r^{th}$ resonator.

It can also be shown that:

$$c_r > 0, G_r > 0 \qquad r = 1 \rightarrow n \qquad (23)$$

To illustrate the use of these explicit formulas, consider the case of n=5. Then:

$$\theta = \frac{\pi}{6}, \cos\theta = \frac{\sqrt{3}}{2} \qquad (24)$$

$$E_o = 1$$

$$E_o E_1 = \frac{\sqrt{3}}{1+\frac{\sqrt{3}}{2}}, E_1 = 2\sqrt{3}(2-\sqrt{3})$$

$$E_1 E_2 = \frac{\sqrt{3}+1}{2\sqrt{}}, E_2 = \frac{5+3\sqrt{3}}{12}$$

$$E_2 E_3 = \frac{\sqrt{3}}{\sqrt{3}+1}, E_3 = 6\sqrt{3}(7-4\sqrt{3})$$

$$E_3 E_4 = -\frac{\sqrt{3}-1}{\sqrt{3}}, E_4 = \frac{5+3\sqrt{3}}{18}$$

$$E_4 E_5 = 0, E_5 = 0$$

Therefore:

$$C_1 = 2(2-\sqrt{3}), G_1 = 7-4\sqrt{3} \qquad (25)$$

$$C_2 = \frac{(9+5\sqrt{3})}{12}, G_2 = \frac{1+\sqrt{3}}{12}$$

$$C_3 = 6(9-5\sqrt{3}), G_3 = 6(7-4\sqrt{3})$$

$$C_4 = \frac{19+11\sqrt{3}}{18}, G_4 = \frac{7+4\sqrt{3}}{18}$$

$$C_5 = 9(3\sqrt{3}-5), G_5 = 9(3\sqrt{3}-5)$$

Also, defining the normalised Q of each resonator as

$$Q_r = \frac{C_r}{G_r} \qquad (26)$$

then from equations (21) and (22):

$$Q_r = \frac{\cos(\frac{\theta}{2}) + \cos(r - \frac{1}{2}\theta)}{\sin(\frac{\theta}{2})} \qquad (27)$$

$$r = 1 \rightarrow n$$

or

$$r = 1 \rightarrow n \qquad (28)$$

$$Q_r = \frac{2\cos\frac{(r\theta)}{2}\cos\frac{(r-1)\theta}{2}}{\sin\frac{\theta}{2}}$$

which directly assists in determining the relative Q's of each cavity.

Consideration will now be given to a quasi equiripple reflection mode filter. Extending the normally maximally flat response to the equiripple case gives:

$$|S_{11}(j\omega)|^2 = \frac{\varepsilon^2 T_n^2(\omega)}{1+\varepsilon^2 T_n^2(\omega)} \qquad (29)$$

where

$$T_n(\omega) = \cos[n \cos^{-1}(\omega)] \qquad (30)$$

and $T_n(\omega)$ is the Chebysher polynomial of $n^{th}$ degree with the resulting lowpass ladder network having infinite Qu and terminated in a 1Ω resistor.

For the case of uniform Qu, it may readily be demonstrated that

$$|S_{11}(j\omega)|^2 = \prod_{r=1}^{n} \frac{(\omega-\omega_r)^2}{[1+(\omega-\omega_r)^2]} \qquad (31)$$

and using optimisation the $\omega_r$, r = 1 → n may be chosen to provide an equiripple response. For example, for n = 7, the $\omega_r$ are 0, ±1.95, ±3.85, ±5.51 to give a 20dB stopband level. However, as in the maximally flat case, as the degree of the network is increased, the selectivity tends to a limit and this prototype has restricted value.

It is not obvious how to extend the desirable maximally flat response given in equation (14) to an equiripple response. However, it is possible to readily generate the quasi equiripple function:

$$|S_{11}(j\omega)|^2=\frac{\alpha^2(1-\omega^2)(1-T_{n+1}^2(\alpha\omega))}{(1-\alpha^2\omega^2)(T_{n+1}^2(\alpha)-T_{n+1}^2(\alpha\omega))} \quad (32)$$

$$(\alpha>1)$$

where $\alpha$ is a constant which determines the ripple level. This function is of degree n in $\omega^2$ due to the cancellation of both the factors $(1-\omega^2)$ and $(1-\alpha^2\omega^2)$. The ripple level in the stopband is given by:

$$L_1=\frac{\alpha^2}{T_{n+1}^2(\alpha)} \quad (33)$$

For $L_1$ = 20dB, then $\alpha$ = 1.100, 1.077, 1.060 for n = 6,7 and 8 respectively. Thus, since $\alpha$ is of the order of unity, the factor

$$\frac{\alpha^2(1-\omega^2)}{(1-\alpha^2\omega^2)} \quad (34)$$

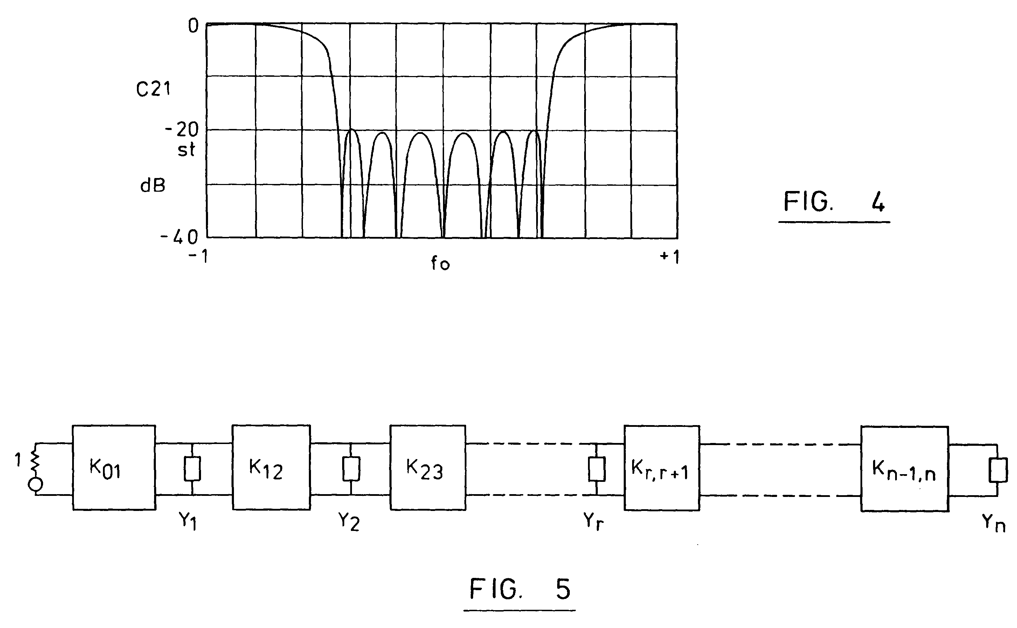

causes very little deviation from the equiripple behaviour. This is illustrated in Fig 4 for the case of n = 7.

Forming the bounded real reflection coefficient from equation (32) gives

$$S_{11}(p,\alpha)=\prod_{r=1}^{n}\left[\frac{(p\alpha-j\cos\theta_r)}{(p\alpha-j\cos(\cos^{-1}(\alpha)+\theta_r)}\right] \quad (35)$$

where

$$\theta_r=\frac{r\pi}{(n+1)} \quad (36)$$

Forming the input impedance:

$$Z(p,\alpha)=\frac{1+S_{11}(p,\alpha)}{1-S_{11}(p,\alpha)} \quad (37)$$

then the ladder structure shown in Fig 5 may be synthesised to give the characteristic admittance of the inverters as:

$$K_{01}=\sqrt{\frac{\sqrt{\alpha^2}-1}{\alpha}} \quad (38)$$

$$K_{r,r+1}=\frac{\sqrt{\alpha^2-\cos^2(\theta r)}}{\alpha}\,r=1\rightarrow n-1$$

$$\theta_r=\frac{r\pi}{(n+1)}$$

and the admittance of the rth shunt element is

$$Y_r=C_r p+G_r\frac{\sqrt{\alpha^2}-1}{\alpha} \quad (39)$$

where $C_r$ and $G_r$ are as given in equation (22).

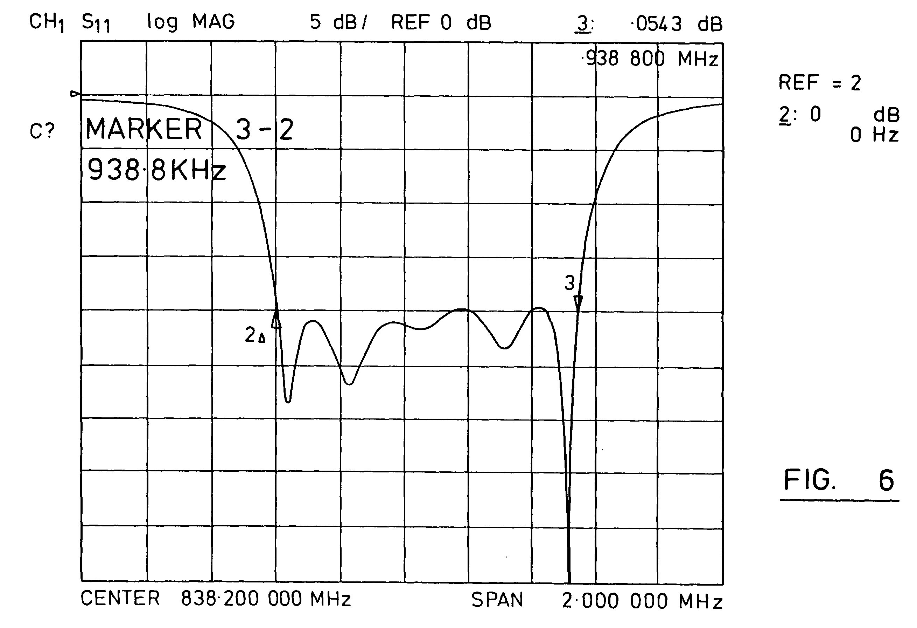

We have constructed and tested two experimental devices in accordance with the invention. The first was of degree 5 with a 20dB stopband of just less than 1 MHz at a centre frequency of 840MHz. The cavities were TEM resonators where the variable Q was obtained by varying the diameters of the cavities. The measured response is shown in Fig 6, showing good agreement with theory. The second device was of degree 6 with a 20dB bandwidth in excess of 1.1MHz and tuned to a similar centre frequency. In this case, energy was decoupled from the last cavity to form a transmission characteristic:

$$|S_{12}(j\omega)|^2=\frac{K^2(1-\omega^2)}{(T_{n+1}^2(\alpha)-T_{n+1}^2(\alpha\omega))} \quad (40)$$

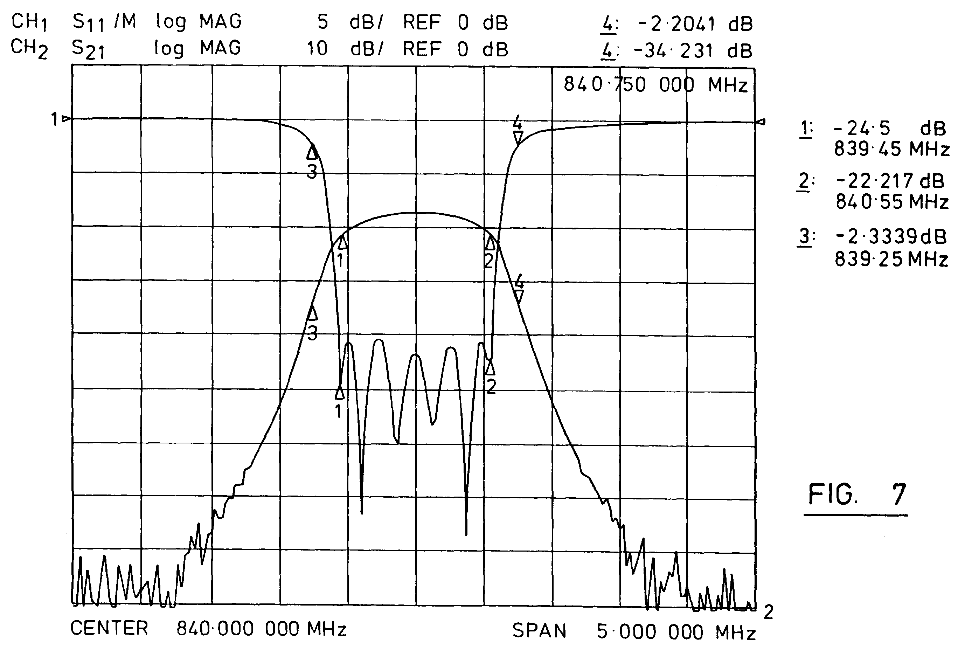

and the measured results in Fig 7 again demonstrate good agreement with theory.

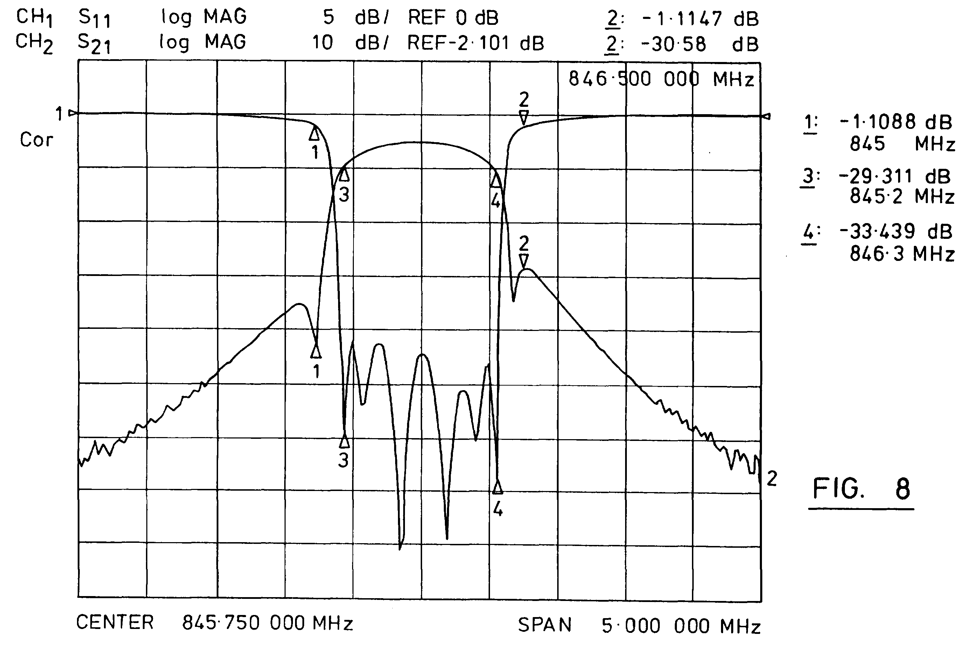

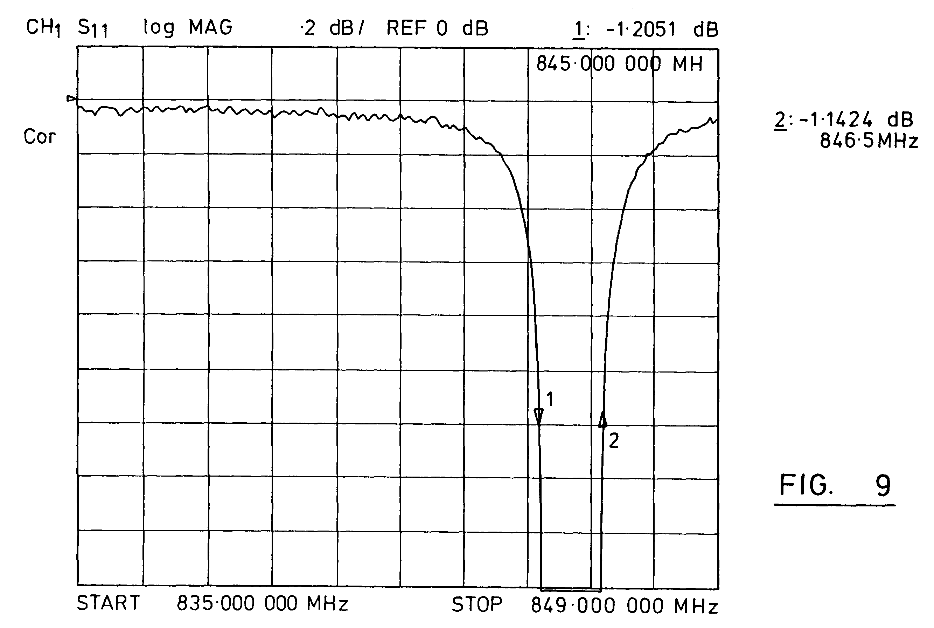

An additional coupling was introduced between the input and the third resonator to produce a pair of real frequency transmission zeros close to the band-edge and then the network was optimised. This had the effect of reducing the reflected loss at the points and measured results are shown in Figs 8 and 9, showing that a significant reduction in loss can be achieved at the passband edges. In this case, the first two cavities were dielectric resonators.

It will be appreciated that in the variable Q reflection mode filters which have been described, the particular choice of the maximally flat and quasi equiripple solutions to the approximation problem have been shown to lead to explicit formulas for the element values in the ladder network realisations. Experimental devices of degree 5 and 6 have been designed and constructed with the measured results showing good agreement with theory. It will also be appreciated that a reciprocal device can be produced by connecting two reflection mode filters to the output ports of a 3dB hybrid.

**Claims**

1. A microwave reflection mode filter comprising a circulator device (12) having first, second and third ports (1,2,3), the first port (1) forming a signal input port and the third port (3) forming a signal output port, and a one-port filter (10) connected to and terminating the second port (2) of the circulator device (12), characterised in that the filter exhibits a maximally flat response and the one-port filter (10) comprises a ladder network of n resonators and having a reflection coefficient given by:

$$S_{11}(p) = \prod_{r=1}^{n} \frac{p^n}{(p - je^{j\theta r})}$$

where $\theta_r$ is a constant applicable to the rth resonator of the ladder and given by:

$$\theta_r = \frac{r\pi}{n+1}$$

and p is the complex frequency variable, the admittance $K_{r-1,r}$ of the inverter coupling between the $(r-1)^{th}$ and $r^{th}$ resonator is given by:

$$K_{r-1,r} = 1 \qquad r = 1 \rightarrow n$$

and the Q factors of the resonators are given by:

$$Q_r = \frac{C_r}{G_r}$$

where $Q_r$ is the Q factor of the rth resonator, $C_r$ is the capacitance of the rth resonator, $G_r$ is the conductance of the rth resonator, and $C_r$ and $G_r$ are defined by

$$C_r = \frac{1}{\cos\theta}\left[\frac{\sin((r-1)\theta)}{E_{r-1}} + \sin(r\theta)E_r\right]$$

$$G_r = \frac{1}{E_{r-1}} - E_r$$

where $E_r$ is a variable applicable to the rth resonator and defined by:

$$E_{r-1}E_r = \left[\frac{\cos\theta + \cos(r\theta)}{\cos\theta + \cos((r-1)\theta)}\right]$$

and:

$$\theta = \frac{\pi}{n+1}$$

2. A microwave reflection mode filter according to claim 1, characterised in that transmission zeros are provided.

3. A microwave reflection mode filter according to claim 2, characterised in that said transmission zeros are formed by coupling provided between the input of the one-port filter (10) and one of its resonators.

4. A microwave reflection mode filter according to claim 3, characterised in that said coupling is provided between the input of the one-port filter (10) and its third resonator.

5. A microwave reflection mode filter comprising a circulator device (12) having first, second and third ports (1,2,3), the first port (1) forming a signal input port and the third port (3) forming a signal output port, and a one-port filter (10) connected to and terminating the second port (2) of the circulator device (12), characterised in that the filter exhibits an equiripple or quasi-equiripple response and said one-port filter (10) comprises a ladder network of n resonators and having a reflection coefficient given by:

$$S_{11}(p,\alpha) = \prod_{r=1}^{n}\left[\frac{(p\alpha - j\cos\theta_r)}{(p\alpha - j\cos(\cos^{-1}(\alpha) + \theta_r))}\right]$$

where $\theta_r$ is a constant applicable to the rth resonator of the ladder and given by:

$$\theta_r = \frac{r\pi}{n+1}$$

and p is the complex frequency variable, $\alpha$ is a constant and the admittances of the inverter couplings are given by:

$$K_{01} = \sqrt{\frac{\sqrt{\alpha^2 - 1}}{\alpha}}$$

$$K_{r,r+1} = \frac{\sqrt{\alpha^2 - \cos^2(\theta r)}}{\alpha} \quad r = 1 \rightarrow n-1$$

the admittance $Y_r$ of the $r^{th}$ resonator is given by

$$Y_r = C_r p + G_r \frac{\sqrt{\alpha^2 - 1}}{\alpha}$$

and the Q factors of the resonators is given by:

$$Q_r = \frac{C_r}{G_r}$$

where $Q_r$ is the Q factor of the rth resonator, $C_r$ is the capacitance of the rth resonator, $G_r$ is the conductance of the rth resonator, and $C_r$ and $G_r$ are defined by:

$$C_r = \frac{1}{\cos\theta}[\frac{\sin((r-1)\theta)}{E_{r-1}} + \sin(r\theta)E_r]$$

$$G_r = \frac{1}{E_{r-1}} - E_r$$

where $E_r$ is a variable applicable to the rth resonator and defined by:

$$E_{r-1}E_r = [\frac{\cos\theta + \cos(r\theta)}{\cos\theta + \cos((r-1)\theta)}]$$

and:

$$\theta = \frac{\pi}{n+1}$$

6. A microwave reflection mode filter according to claim 5, characterised in that transmission zeros are provided.

7. A microwave reflection mode filter according to claim 6, characterised in that said transmission zeros are formed by coupling provided between the input of the one-port filter (10) and one of its resonators.

8. A microwave reflection mode filter according to claim 7, characterised in that said coupling is provided between the input of the one-port filter (10) and its third resonator.

**Patentansprüche**

1. Mikrowellen-Reflexionsfilter mit einem Zirku latorbauelement (12) mit einem ersten, zweiten und dritten Port (1, 2, 3), wobei der erste Port (1) einen Signaleingangspart bildet und der dritte Port (3) einen Signalausgangsport bildet, und einem Ein-Port-Filter (10), das mit dem zweiten Port (2) des Zirkulatorbauelements (12) verbunden ist und diesen abschließt, dadurch gekennzeichnet, daß das Filter einen maximal flachen Frequenzgang aufweist und das Ein-Port-Filter (10) ein Kettenleiternetzwerk aus n Resonatoren umfaßt und einen Reflexionskoeffizienten aufweist, der durch

$$S_{11}(p) = \prod_{r=1}^{n} \frac{p^n}{(p - je^{j\theta r})}$$

gegeben ist, wobei $\theta_r$ eine Konstante ist, die auf den r-ten Resonator der Kettenleiter anwendbar ist und durch

$$\theta_r = \frac{r\pi}{n+1}$$

gegeben ist, und p die komplexe Frequenzvariable ist und die Admittanz $K_{r-1,r}$ der Inverterkopplung zwischen dem (r-1)-ten und r-ten Resonator durch

$$K_{r-1,r} = 1 \qquad r = 1 \rightarrow n$$

gegeben ist und die Gütefaktoren der Resonatoren durch

$$Q_r = \frac{C_r}{G_r}$$

gegeben sind, wobei $Q_r$ der Gütefaktar des r-ten Resonators, $C_r$ die Kapazität des r-ten Resonators und $G_r$ die Konduktanz des r-ten Resonators ist und $C_r$ und $G_r$ durch

$$C_r = \frac{1}{\cos\theta}[\frac{\sin((r-1)\theta)}{E_{r-1}} + \sin(r\theta)E_r]$$

$$G_r = \frac{1}{E_{r-1}} - E_r$$

definiert sind, wobei $E_r$ eine Variable ist, die auf den r-ten Resonator anwendbar ist und durch

$$E_{r-1}E_r = [\frac{\cos\theta + \cos\theta(r\theta)}{\cos\theta + \cos((r-1)\theta)}]$$

und

$$\theta = \frac{\pi}{n+1}$$

definiert ist.

2. Mikrowellen-Reflexionsfilter nach Anspruch 1, dadurch gekennzeichnet, daß Übertragungsnullstellen bereitgestellt werden.

3. Mikrowellen-Reflexionsfilter nach Anspruch 2, dadurch gekennzeichnet, daß die Übertragungsnullstellen durch zwischen dem Eingang des Ein-Port-Filters (10) und einem seiner Resonatoren bereitgestellte Kopplung gebildet werden.

4. Mikrowellen-Reflexionsfilter nach Anspruch 3, dadurch gekennzeichnet, daß die Kopplung zwischen dem Eingang des Ein-Port-Filters (10) und seinem dritten Resonator bereitgestellt wird.

5. Mikrowellen-Reflexionsfilter mit einem Zirkulatorbauelement (12) mit einem ersten, zweiten und dritten Port (1, 2, 3), wobei der erste Port (1) einen Signaleingangsport bildet und der dritte Port (3) einen Signalausgangsport bildet, und einem Ein-Port-Filter (10), das mit dem zweiten Port (2) des Zirkulatorbauelements (12) verbunden ist und diesen abschließt, dadurch gekennzeichnet, daß das Filter einen Frequenzgang mit abstandsgleicher oder quasi-abstandsgleicher Welligkeit aufweist und das Ein-Port-Filter (10) ein Kettenleiternetzwerk aus n Resonatoren umfaßt und einen Reflexionskoeffizienten aufweist, der durch

$$S_{11}(p,\alpha)=\prod_{r=1}^{n}[\frac{(p\alpha\text{-}jcos\theta_r)}{(p\alpha\text{-}jcos(cos^{-1}(\alpha)+\theta_r)}]$$

gegeben ist, wobei $\theta_r$ eine Konstante ist, die auf den r-ten Resonator der Kettenleiter anwendbar ist und durch

$$\theta_r=\frac{r\pi}{n+1}$$

gegeben ist, und p die komplexe Frequenzvariable und $\alpha$ eine Konstante ist und die Admittanzen der Inverterkopplungen durch

$$K_{01}=\sqrt{\frac{\sqrt{\alpha^2\text{-}1}}{\alpha}}$$

$$K_{r,r+1}=\frac{\sqrt{\alpha^2\text{-}cos^2(\theta r)}}{\alpha} r=1\rightarrow n\text{-}1$$

gegeben sind, die Admittanz $Y_r$ des r-ten Resonators durch

$$Y_r=C_r p+G_r\frac{\sqrt{\alpha^2\text{-}1}}{\alpha}$$

und die Gütefaktoren der Resonatoren durch

$$Q_r=\frac{C_r}{G_r}$$

gegeben sind, wobei $Q_r$ der Gütefaktor des r-ten Resonators, $C_r$ die Kapazität des r-ten Resonators und $G_r$ die Konduktanz des r-ten Resonators ist und $C_r$ und $G_r$ durch

$$C_r=\frac{1}{cos\theta}[\frac{sin((r\text{-}1)\theta)}{E_{r\text{-}1}}+sin(r\theta)E_r]$$

$$G_r=\frac{1}{E_{r\text{-}1}}\text{-}E_r$$

definiert sind, wobei $E_r$ eine Variable ist, die auf den r-ten Resonator anwendbar ist und durch

$$E_{r\text{-}1}E_r=[\frac{cos\theta+cos(r\theta)}{cos\theta+cos((r\text{-}1)\theta)}]$$

und

$$\theta=\frac{\pi}{n+1}$$

definiert ist.

6. Mikrowellen-Reflexionsfilter nach Anspruch 5, dadurch gekennzeichnet, daß Übertragungsnullstellen bereitgestellt werden.

7. Mikrowellen-Reflexionsfilter nach Anspruch 6, dadurch gekennzeichnet, daß die Übertragungsnullstellen durch zwischen dem Eingang des Ein-Port-Filters (10) und einem seiner Resonatoren bereitgestellte Kopplung gebildet werden.

8. Mikrowellen-Reflexionsfilter nach Anspruch 7, dadurch gekennzeichnet, daß die Kopplung zwischen dem Eingang des Ein-Port-Filters (10) und seinem dritten Resonator bereitgestellt wird.

**Revendications**

1. Filtre de mode à réflexion hyperfréquence comprenant un dispositif circulateur (12) ayant des premier, deuxième et troisième ports (1, 2, 3), le premier port (1) formant un port d'entrée de signaux et le troisième port (3) formant un port de sortie de signaux, et un filtre à un port (10) connecté au et terminant le deuxième port (2) du dispositif circulateur (12), caractérisé en ce que le filtre présente une réponse maximalement plate et le filtre à un port (10) comprend un réseau en échelle de n résonateurs et ayant un coefficient de réflexion donné par:

$$S_{11}(p)=\prod_{r=1}^{n}\frac{p^{n}}{(p-je^{j\theta r})}$$

où $\theta_r$ est une constante applicable au $r^e$ résonateur de l'échelle et donnée par:

$$\theta_r=\frac{r\pi}{n+1}$$

et p est la variable de fréquence complexe, l'admittance $K_{r-1,r}$ du couplage inverseur entre le $(r-1)^e$ et le $r^e$ résonateur est donnée par:

$$K_{r-1,r}=1 \qquad r=1\rightarrow n$$

et les facteurs Q des résonateurs sont donnés par:

$$Q_r=\frac{C_r}{G_r}$$

où $Q_r$ est le facteur Q du $r^e$ résonateur, $C_r$ est la capacité du $r^e$ résonateur, $G_r$ est la conductance du $r^e$ résonateur, et $C_r$ et $G_r$ sont définies par:

$$C_r=\frac{1}{\cos\theta}[\frac{\sin((r-1)\theta)}{E_{r-1}}+\sin(r\theta)E_r]$$

$$G_r=\frac{1}{E_{r-1}}-E_r$$

où $E_r$ est une variable applicable au $r^e$ résonateur et définie par:

$$E_{r-1}E_r=[\frac{\cos\theta+\cos(r\theta)}{\cos\theta+\cos((r-1)\theta)}]$$

et:

$$\theta=\frac{\pi}{n+1}$$

2. Filtre de mode à réflexion hyperfréquence selon la revendication 1, caractérisé en ce que des zéros de transmission sont fournis.

3. Filtre de mode à réflexion hyperfréquence selon la revendication 2, caractérisé en ce que lesdits zéros de transmission sont formés par un couplage assuré entre l'entrée du filtre à un port (10) et l'un de ses résonateurs.

4. Filtre de mode à réflexion hyperfréquence selon la revendication 3, caractérisé en ce que ledit couplage est assuré entre l'entrée du filtre à un port (10) et son troisième résonateur.

5. Filtre de mode à réflexion hyperfréquence comprenant un dispositif circulateur (12) ayant des premier, deuxième et troisième ports (1, 2, 3), le premier port (1) formant un port d'entrée de signaux et le troisième port (3) formant un port de sortie de signaux, et un filtre à un port (10) connecté au et terminant le deuxième port (2) du dispositif circulateur (12), caractérisé en ce que le filtre présente une réponse ondulation ou quasi-ondulation et ledit filtre à un port (10) comprend un réseau en échelle de n résonateurs et ayant un coefficient de réflexion donné par:

$$S_{11}(p,\alpha)=\prod_{r=1}^{n}[\frac{(p\alpha-j\cos\theta_r)}{(p\alpha-j\cos(\cos^{-1}(\alpha)+\theta_r))}]$$

où $\theta_r$ est une constante applicable au $r^e$ résonateur de l'échelle et donnée par:

$$\theta_r=\frac{r\pi}{n+1}$$

et p est la variable de fréquence complexe, $\alpha$ est une constante et les admittances des couplages inverseurs sont données par:

$$K_{01}=\sqrt{\frac{\sqrt{\alpha^2-1}}{\alpha}}$$

$$K_{r,r+1}=\frac{\sqrt{\alpha^2-\cos^2(\theta r)}}{\alpha}r=1\rightarrow n-1$$

l'admittance $Y_r$ du $r^e$ resonateur est donnée par:

$$Y_r=C_r p+G_r\frac{\sqrt{\alpha^2-1}}{\alpha}$$

et les facteurs Q des résonateurs sont donnés par:

$$Q_r=\frac{C_r}{G_r}$$

où $Q_r$ est le facteur Q du $r^e$ résonateur, $C_r$ est la

capacité du $r^e$ résonateur, $G_r$ est la conductance du $r^e$ résonateur, et $C_r$ et $G_r$ sont définies par:

$$C_r = \frac{1}{\cos\theta}[\frac{\sin((r\text{-}1)\theta}{E_{r\text{-}1}} + \sin(r\theta)E_r)$$

$$G_r = \frac{1}{E_{r\text{-}1}} - E_r$$

où $E_r$ est une variable applicable au $r^e$ résonateur et définie par:

$$E_{r\text{-}1}E_r = [\frac{\cos\theta + \cos(r\theta)}{\cos\theta + \cos((r\text{-}1)\theta)}]$$

et:

$$\theta = \frac{\pi}{n+1}$$

6. Filtre de mode à réflexion hyperfréquence selon la revendication 5, caractérisé en ce que des zéros de transmission sont fournis.

7. Filtre de mode à réflexion hyperfréquence selon la revendication 6, caractérisé en ce que lesdits zéros de transmission sont formés par un couplage assuré entre l'entrée du filtre à un port (10) et l'un de ses résonateurs.

8. Filtre de mode à réflexion hyperfréquence selon la revendication 7, caractérisé en ce que ledit couplage est assuré entre l'entrée du filtre à un port (10) et son troisième résonateur.

FIG. 1

FIG. 2

FIG. 3

12

EP 0 734 594 B1

FIG. 4

FIG. 5

CH$_1$ S$_{11}$   log MAG      5 dB /  REF 0 dB        3:    ·0543 dB

·938 800 MHz

REF = 2

2: 0      dB
      0 Hz

C?  MARKER  3 – 2
    938·8KHz

2△

3

CENTER  838·200 000 MHz        SPAN   2·000 000 MHz

EP 0 734 594 B1

FIG.   6

CH₁ S₁₁ /M log MAG 5 dB/ REF 0 dB  4: -2·2041 dB
CH₂ S₂₁ log MAG 10 dB/ REF 0 dB  4: -34·231 dB

840·750 000 MHz

1: -24·5 dB
839·45 MHz

2: -22·217 dB
840·55 MHz

3: -2·3339dB
839·25 MHz

CENTER 840·000 000 MHz    SPAN 5·000 000 MHz

FIG. 7

EP 0 734 594 B1

CH₁  S₁₁    log MAG      5  dB/  REF 0 dB        2: -1·1147 dB
CH₂  S₂₁    log MAG     10  dB/  REF-2·101 dB    2: -30·58  dB

846·500 000 MHz

1: -1·1088 dB
    845   MHz

3: -29·311 dB
    845·2 MHz

4: -33·439 dB
    846·3 MHz

CENTER   845·750 000 MHz          SPAN   5·000 000 MHz

FIG. 8

EP 0 734 594 B1

CH₁ S₁₁　log MAG　　·2 dB/　REF 0 dB　　　1: -1·2051 dB

Cor

845·000 000 MH

2: -1·1424 dB
846·5MHz

1

2

START　　835·000 000 MHz　　　STOP　849·000 000 MHz

EP 0 734 594 B1

FIG.　9